# EUROPEAN PATENT SPECIFICATION

(11) **EP 0 390 188 B1**
(45) Date of publication and mention of the grant of the patent: **28.08.1996**
(21) Application number: 90106152.3
(22) Date of filing: 30.03.1990
(51) Int. Cl.: B29C 59/14, C08J 7/18, C23C 14/20

(54) **Formed articles based on polymeric material and showing improved wettability and adhesion and process for the production thereof**
Formkörper auf Kunststoffbasis mit verbesserter Benetzbarkeit und Haftung sowie Verfahren zu deren Herstellung
Articles moulés à base de matériau polymère à mouillabilité et adhérence augmentées, et procédé de leur production

(30) Priority: 31.03.1989 IT 1997389
(43) Date of publication of application: 03.10.1990
(73) Proprietor: ENICHEM S.p.A., I-20124 Milano (IT)
(72) Inventor: Occhiello, Ernesto, Dr. Chem., I-28100 Novara (IT); Morra, Marco, Dr.Ind. Chem., I-14040 Cortiglione, Asti (IT); Garbassi, Fabio, Dr. Chem., I-28100 Novara (IT)
(74) Representative: Weinhold, Peter, Dr.

(56) References cited:
- EP-A- 0 187 706
- GB-A- 2 105 729
- APPLIED PHYSICS. LETT., vol. 33, no. 5, September 1978, pages 387-389; J.M. BURKSTRAND: "Formation of a copper-oxygen-polymer complex on polystyrene"

## Description

The present invention relates to formed articles based on a non-elastomeric material having improved wettability and adhesion to coatings. Furthermore, the invention relates to a process for improving the wettability and adhesion to coatings of surfaces of formed articles based on non-elastomeric polymeric materials.

Most of the commonly used methods for improving the wettability and adhesion of polymeric surfaces are described by S. Wu in "Polymer Interface and Adhesion", Marcel Dekker Publisher; New York 1982, and can be divided into chemical treatments and physical treatments.

The former treatment may comprise chemical attack of the surface by means of solutions which, depending on the polymer type, may be acidic, basic and/or oxidising. However, this type of treatment requires the use of aggressive liquids which are potentially harmful and toxic for the working environment and, furthermore, have to be disposed of once they are not needed anymore. Another chemical method which is widely adopted, mainly in order to obtain a better coatability, comprises the application of a primer. The primer is a substance which gives rise to an intermediate layer between polymer and coating (or adhesive) and which, therefore, optimizes the interaction therebetween. The main drawback of said treatment is the necessity of applying a very thin layer, the thickness of which must carefully be controlled. Secondly, the use of toxic solvents frequently is required.

Among the physical treatments, flame and corona discharge treatments are not most frequently resorted to. In both cases, the drawbacks are mainly associated with the difficulty of obtaining a uniform treatment on articles of complex shape. In the case of corona discharge treatments a reduced efficiency and a rapid decay in the course of time are often observed as well.

The GB-A-2 105 729 describes a process for surface processing a heat sensitive substrate material by exposing the surface of the substrate to a high intensity pulsed plasma. To extend the use of the plasma process, for instance, to include metal atoms, the plasma treatment is coupled with a sputtering treatment. Such a process, however, requires a high energy beam for the sputtering treatment and an independent sputtering apparatus.

It has now been found that it is possible to successfully produce formed articles based on polymeric material and having improved wettability and adhesion without encountering the above drawbacks.

According to the present invention, these results are obtained when the formed article has on its surface a modified polymeric layer containing repeating monomeric units like the ones of the substrate, the same monomeric units in an oxidized and/or cross linked form and an inorganic filler selected from metals or semi-metals in elemental form and/or in the form of an oxide, said layer being interpenetrated by the non-modified polymer of the substrate.

Thus, the present invention provides formed articles based on non-elastomeric polymeric material comprising a modified polymeric surface layer containing
(i) repeating monomeric units like the ones of the non-elastic polymeric material,
(ii) some or all of these monomeric units being oxidized and/or crosslinked, and
(iii) one or more inorganic fillers selected from metals and semi-metals in elemental form and/or in the form of an oxide,
said inorganic filler(s) being present in an atomic concentration of from 1 to 10%, as determined by XPS analysis, and said modified polymer being interpenetrated by the non-modified polymer of the substrate.

The process for producing such formed articles having a modified polymeric surface layer forming an interpenetrated polymer network comprises subjecting a formed article to a combined plasma-sputtering treatment and consists in introducing the formed article into the lower portion of a vacuum chamber and treating said formed article with a low pressure plasma in the presence, inside the upper portion of said vacuum chamber, of an electrode connected to a radio-frequency energy generator while maintaining earthed the lower portion of said vacuum chamber, said electrode consisting of the inorganic filler in the elemental form or in the form of an oxide, whereby an atomic concentration ranging from 1 to 10% of the filler in the polymeric surface layer is achieved, as determined by XPS analysis.

The thickness of said modified polymeric surface layer generally does not exceed 50 nm and preferably ranges from 0.1 to 15, particularly from 1 to 10 nm.

Control of the amount of metal, semi-metal and/or oxide and of the degree of polymer oxidation and/or cross-linking is achieved by adjusting the typical parameters of the apparatus, i.e., output, pressure, treatment times etc. according to known techniques.

According to a particularly advantageous embodiment of the present invention, a formed article, for example a small plate, is introduced into a vacuum chamber and is then treated with a low pressure plasma (0.1 - 20 Pa) according to known techniques. At the same time, a controlled amount of a metal and/or semi-metal and/or oxide is deposited on the polymeric surface by means of a process known as "sputtering" (evaporation of metal or semi-metal atoms and/or ions by means of ion bombardment, and deposition thereof on the surface to be treated). Details concerning said sputtering process are described, for example, by J.L.Vossen and W.Kern in "Thin Film Processes" (Academic Press Publishers; New York, 1978; pages 12 to 73).

The process according to the present invention can be utilized to particular advantage for the production of formed bodies based on any polymeric non-elastomeric material such as, for example, polymers and copolymers of olefinic and diolefinic compounds (ethylene, propylene, butenes, etc.), polymers and copolymers of vinyl monomers such as styrene, alpha-methyl-styrene, maleic anhydride, acrylonitrile, methacrylonitrile, acrylic acid, methacrylic acid, alkyl acrylates, alkyl-methacrylates, vinyl chloride, vinylidene fluoride, butadiene,chloroprene, isoprene etc.; polyesters and copolyesters, thermotropic crystalline liquid polymers, phenol-formaldehyde resins, ureic resins, melaminic resins, polyamides, polyurethanes, epoxy resins, polyphenylene oxides, polythermoimidic resins, styrene-maleic anhydride imidized copolymers, olefin-CO and olefin-SO₂ copolymers, acetalic resins, mixtures thereof, etc.

The natures of the metals and semi-metals used as electrode material can differ considerably. In the present examples aluminum which is easy to evaporate and is readily available has mainly been employed. Analogous results can, however, be obtained by using other metals such as copper, indium, tin etc., or by using semi-metals, such as silicon, and mixtures thereof and the corresponding oxides.

Regarding the gas for the plasma, it is possible to use oxidizing gases (in particular air and oxygen) and inert gases (noble gases, nitrogen, etc.) with substantially equivalent results. The devices for carrying out the sputtering can be of different type, as reported, for example, by J.L. Vossen and W. Kern in the above publication.

The treatment based on gaseous plasma at low pressure contemporaneously with the sputtering treatment leads to the production of formed articles based on non-elastomeric polymeric material and having a high wettability and adhesiveness, coated with a surface layer of modified polymeric material which is intimately interpenetrated by the substrate,forming therewith what is known as an interpenetrating polymer network (IPN). In other words, the modified material, oxidized and/or cross-linked by the treatment with plasma and containing an inorganic filler, is intimately interpenetrated by the underlying original polymeric material having been produced in the direct presence of the original substrate. As to the definition of "IPN", reference is made to the article "Interpenetrating Polymer Networks" by D.Klempner and L.Berkowski, published in Encyclopaedia of Polymer Science and Technology (vo.. 8, page 279), Wiley and Sons editors, New York; 1987.

The products obtainable by the process according to the present invention may usefully be applied e.g. in the automotive sector as bumpers and other parts of vehicles, the coatability and glueing capability thereof being promoted, as well as in the sector of household electrical apparatus and appliances and the electronic industry, the metallization of the component parts made of plastic material being favoured.

A few illustrative examples, which by no way shall limit the scope of the invention, are given thereinafter.

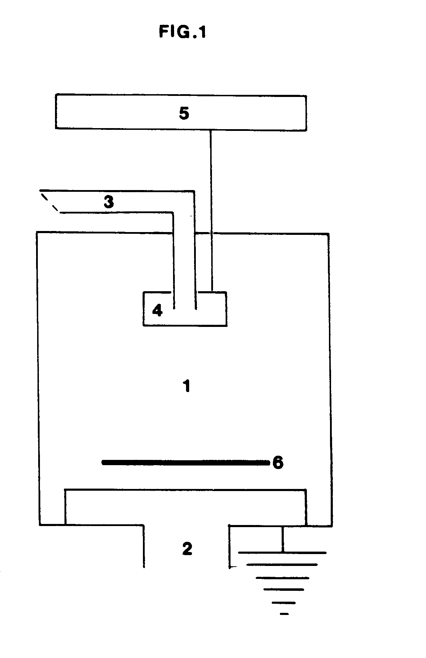

In all examples, a cylindrical aluminum reactor, the cross-section of which is schematically shown in Fig.1, was used. With reference to said Fig.1, in a cylindrical chamber (1), having an inside diameter of about 40 cm and a height of about 30 cm, vacuum was generated by means of a pumping device (2) capable of reaching pressures of the order of 0.05 Pa. The gases necessary for the treatment were introduced into the reactor by means of electronically controlled flowmeters (3). Inside the chamber, in the upper portion, an electrode (4) was arranged, which electrode was connected to an advanced energy generator MTN 500 (5), having an output of from 0 to 500 W at 13.56 MHz. The formed body to be treated was introduced into the lower portion of the reactor. While the remaining part of the chamber was maintained earthed, the radio-frequency indicated in the examples was applied to the upper electrode (4). The application of the radio-frequency to the upper electrode induced the formation of a negative potential which attracted the positive ions present in the plasma. The ion bombardment of the electrode (4) induced the emission (sputtering) of atoms and/or of charged and neutral agglomerates, which deposited on the surface of the test-piece (6).

### Example 1

Small plates of isotactic polypropylene (12.5x12.5x0.3 cm) were treated with oxygen and argon plasmas (in the above-described reactor), with simultaneous deposition of aluminum oxide (by means of sputtering). The conditions were as follows:

| | |
|---|---|
| Electrode material | aluminium |
| Radio-frequency | 13.56 MHz |
| Output | 100 W |
| Pressure | 2 Pa |
| Gas flow | 8 cm³ (STP)/minute (*) |
| Treatment time | 30 seconds |

| | |
|---|---|
| (*) STP = under standard conditions (at 25°C and at atmospheric pressure). | |

After said treatment, the plates were analyzed by means of XPS spectroscopy (X-ray Photoelectron Spectroscopy), in order to determine the amount of aluminum introduced during the treatment. A description of the XPS method may be found in "Practical Surface Analysis" by M.Seah and D.Briggs (published by Wiley; New York 1983, pages 359 to 396). To evaluate the effect of the treatment on the wettability, the water advancing (contact) angle was measured, as described in the above book by S.Wu, pages 133 to 168. The smaller the water advancing angle, the higher is the wettability and therefore the higher is the surface tension. In the treated materials, a complete wettability with water was observed (advancing angle = 0), corresponding to a surface tension equal to or higher than 72.8 mJ/m².

Some plates were then coated with a layer, having a thickness of about 0.04 micrometers, of metallic aluminum, by evaporating the same under vacuum, according to the processes usually used for packaging films.

Other plates were coated with a conventional nitrocellulose lacquer (for cars). In both cases the adhesion was evaluated by means of the scotch tape test according to ASTM D. 3359. The adhesiveness scale of said standard ranges from OB to 5B, the latter value characterizing the maximum adhesiveness. In all cases, substantial improvements as compared to the untreated material were observed. In particular, the maximum adhesiveness level contemplated in the cited standard was reached. The data relating to untreated plates and to plates treated with oxygen and argon plasmas are reported in table 1. Indicated therein are: the Al concentration, expressed as atomic percentage; the water advancing angle, expressed in degrees; the adhesion of the aluminum layer, according to ASTM D. 3359. and the lacquer adhesiveness, according to ASTM D. 3359.

**TABLE 1**

| TREATMENT | Al (%) | ADVANCING ANGLE | METAL ADHESIVENESS | LACQUER ADHESIVENESS |
|---|---|---|---|---|
| None | 0 | 95 | 0B | 0B |
| O₂ plasma | 5 | 0 | 5B | 5B |
| Ar plasma | 2 | 0 | 5B | 5B |

### Example 2

Polyethylene terephthalate plates (6x6x0.3 cm) were treated with oxygen or nitrogen plasma in the above-described reactor, with simultaneous deposition, by means of sputtering, of aluminum oxide. The operative conditions were identical with the ones indicated in example 1, and the characterization of the chemical composition and the wettability was carried out analogously. Also in this case, a substantial improvement as a consequence of the treatment was observed. Some plates were then coated with a nitrocellulose lacquer (for cars), and the adhesiveness was measured by means of the scotch tape test according to ASTM D. 3359. Again, considerable improvements as compared to the untreated material were observed (maximum adhesiveness level contemplated in the cited standards).

Table 2 shows the results obtained with untreated plates and plates treated with oxygen and nitrogen plasmas.

**TABLE 2**

| TREATMENT | Al (%) | ADVANCING ANGLE | LACQUER ADHESIVENESS |
|---|---|---|---|
| None | 0 | 81 | 3B |
| O₂ plasma | 2 | 0 | 5B |
| N₂ plasma | 2 | 0 | 5B |

### Example 3

Plates prepared from a thermotropic liquid crystalline polymer based on polyester (commercially known as GRANLAR® 6x5x0.3 cm) were treated with an air plasma in the above-described reactor, with simultaneous deposition of aluminum oxide by means of sputtering. The operative conditions were identical with the ones indicated in example 1, and the characterization of chemical composition and wettability was carried out analogously. Also in this case it was possible to observe a substantial improvement as consequence of the treatment. Some plates were then coated with a nitrocellulose lacquer (for cars) and the adhesiveness was determined by means of the scotch tape test according to ASTM D. 3359. Other plates were metallized in accordance with the method described in example 1. Substantial improvements were observed both in the case of the metallized plates and in the case of the coated plates, in comparison with the untreated material (maximum adhesiveness level contemplated in the cited standards).

Table 3 shows the results obtained with the untreated plates and the plates treated with air plasma.

**TABLE 3**

| TREATMENT | Al (%) | ADVANCEMENT ANGLE | METAL ADHESIVENESS | LACQUER ADHESIVENESS |
|---|---|---|---|---|
| None | 0 | 58 | 0B | 0B |
| Air plasma | 7 | 0 | 5B | 5B |

### Example 4 (comparative)

Isotactic polypropylene plates (12.5x12.5x0.3 cm) and plates prepared from a thermotropic crystalline liquid polymer based on polyester (commercially known as GRANULAR®, measuring 6x5x0.3 cm) were treated with oxygen plasma in the above-described reactor, but in the absence of sputtering of metals and/or semi-metals on the surface. The plasma parameters were maintained the same as indicated in example 1. An analysis of the treated surfaces by means of XPS spectroscopy did not reveal any presence of metals and/or semi-metals on the surfaces of the manufactured articles. A reduction of the water advancement angle as compared to the untreated plates (better wettability) could be observed, although to a smaller extent as in the case of the additional sputtering of metals and/or semi-metals.

Some plates were then coated with a nitrocellulose lacquer (for cars) and the adhesiveness was determined by means of the scotch tape test according to ASTM D. 3359. Again, improvements as compared to the untreated material could be observed, but the maximum adhesiveness level contemplated by the cited standard was not reached. Data and results are reported in table 4.

**TABLE 4**

| POLYMER | ADVANCEMENT ANGLE | LACQUER ADHESIVENESS |
|---|---|---|
| Polypropylene | 34 | 3B |
| Liquid crystalline polyester (GRANLAR®) | 48 | 2B |

## Claims

1. A process for producing formed articles based on non-elastomeric polymeric material, having improved wettability and adhesiveness, wherein the formed articles are subjected to a combined plasma-sputtering treatment in order to obtain a modified polymeric surface layer forming an interpenetrated polymer network containing:
(i) repeating monomeric units corresponding to the ones of the nonelastic polymeric material,
(ii) the same oxidized and/or crosslinked monomeric units, and
(iii) one or more inorganic fillers consisting of metal or semi-metal elements or their oxides,
the process consisting in
a) introducing the formed article into the lower portion of a vacuum chamber, and
b) treating said formed article with a low pressure plasma in the presence, inside the upper portion of said vacuum chamber, of an electrode connected to a radio-frequency energy generator while maintaining earthed the lower portion of said vacuum chamber, said electrode consisting of the inorganic filler (iii) in the elemental form or in the form of an oxide, whereby an atomic concentration ranging from 1 to 10% of the filler (iii) in the polymeric surface layer is achieved, as determined by XPS analysis.

2. Process according to claim 1 wherein the electrode is made of one or more of aluminum, copper, indium, tin, silicon and oxides thereof.

3. Process according to any one of claims 1 and 2 wherein the plasma treatment is conducted at a pressure of from 0.1 to 20 Pascal, the plasma preferably being selected from oxygen, air, nitrogen and noble gas plasmas or mixtures thereof.

4. Formed articles based on non-elastomeric polymeric material comprising a modified polymeric surface layer containing
(i) repeating monomeric units like the ones of the nonelastic polymeric material,
(ii) some or all of these monomeric units being oxidized and/or crosslinked, and
(iii) one or more inorganic fillers selected from metals and semi-metals in elemental form and/or in the form of an oxide,
said inorganic filler(s) being present in an atomic concentration of from 1 to 10%, as determined by XPS analysis, and said modified polymer being interpenetrated by the non-modified material of the substrate.

5. Articles according to claim 4 in which the thickness of the modified polymeric surface layer does not exceed 50nm and preferably ranges from 0.1 to 15nm.

6. Articles according to claim 5 in which the thickness of the modified polymeric surface layer ranges from 1 to 10nm.

7. Articles according to any of the preceding claims in which the metal or semi-metal is selected from aluminum, copper, indium, tin, silicon or mixtures thereof.

8. Article according to claim 7 in which the metal is aluminum.

9. Article according to any of claims 7 and 8 in which the metal or semi-metal is present in the form of an oxide.

## Patentansprüche

1. Verfahren zur Herstellung von Formkörpern auf der Basis eines nicht-elastomeren polymeren Materials mit verbesserter Benetzbarkeit und Haftung, wobei die Formkörper einer kombinierten Plasmabehandlung und -beschichtung durch Vakuumzerstäubung unterzogen werden, um eine modifizierte polymere Oberflächenschicht zu erhalten, die ein ineinandergreifendes polymeres Netzwerk bildet, das enthält:
(i) Wiederkehrende Monomereinheiten, die denen des nicht-elastischen polymeren Materials entsprechen,
(ii) die gleichen oxidierten und/oder vernetzten monomeren Einheiten und
(iii)ein oder mehrere anorganische Füllmittel, bestehend aus Metall- oder Halbmetall-Elementen oder deren Oxiden,
wobei das Verfahren besteht aus:
a) Einführen des Formkörpers in den unteren Teil einer Vakuumkammer und
b) Behandlung des genannten Formkörpers mit einem Niederdruckplasma in Anwesenheit - innerhalb des oberen Teils der genannten Vakuumkammer - einer Elektrode, die mit einem Radiofrequenzenergiegenerator verbunden ist, während der untere Teil der genannten Vakuumkammer geerdet bleibt, wobei die genannte Elektrode aus dem anorganischen Füllmittel (iii) als Element oder in Form eines Oxids besteht, wodurch eine atomare Konzentration von 1 bis 10 % des Füllmittels (III) in der polymeren Oberflächenschicht erzielt wird, was durch XPS-Analyse bestimmt wird.

2. Verfahren nach Anspruch 1, wobei die Elektrode aus einem oder mehreren Materialien wie Aluminium, Kupfer, Indium, Zinn, Silizium und Oxiden davon besteht.

3. Verfahren nach einem der Ansprüche 1 und 2, wobei die Plasma-Behandlung bei einem Druck von 0,1 bis 20 Pascal durchgeführt wird, und das Plasma vorzugsweise ausgewählt wird aus Sauerstoff-, Luft-, Stickstoff- und Edelgasplasmen oder Mischungen von diesen.

4. Formkörper auf der Basis eines nicht-elastomeren polymeren Materials, die eine modifizierte polymere Oberflächenschicht umfassen, die enthält:
(i) Wiederkehrende monomere Einheiten wie jene des nicht-elastomeren polymeren Materials,
(ii) einige oder alle dieser monomeren Einheiten in oxidierter und/oder vernetzter Form und
(iii) ein oder mehrere anorganische Füllmittel, ausgewählt aus Metallen und Halbmetallen in elementarer Form und/oder in Form eines Oxids,
wobei das (die) genannte(n) Füllmittel in einer atomaren Konzentration von 1 bis 10% anwesend ist (sind), was durch XPS-Analyse bestimmt wird, und wobei das genannte modifizierte Polymer von dem nicht-modifzierten Material des Substrats durchdrungen ist.

5. Formkörper nach Anspruch 4, wobei die Dicke der modifizierten polymeren Oberflächenschicht 50 nm nicht übersteigt und vorzugsweise 0,1 bis 15 nm beträgt.

6. Formkörper nach Anspruch 5, wobei die Dicke der modifizierten polymeren Oberflächenschicht von 1 bis 10 nm beträgt.

7. Formkörper nach einem der vorhergehenden Ansprüche, wobei das Metall oder das Halbmetall ausgewählt wird aus Aluminium, Kupfer, Indium, Zinn, Silizium oder Mischungen davon.

8. Formkörper nach Anspruch 7, wobei das Metall Aluminium ist.

9. Formkörper nach einem der Ansprüche 7 und 8, wobei das Metall oder Halbmetall in Form eines Oxids anwesend ist.

## Revendications

1. Procédé de préparation de pièces moulées à base d'une matière polymère non élastomère ayant des propriétés améliorées de mouillabilité et d'adhérence, dans lequel on soumet les pièces moulées à un traitement combiné de pulvérisation cathodique assistée par plasma afin d'obtenir une couche superficielle de polymère modifié formant un réseau de polymères qui s'interpénètrent et qui contiennent :
(i) des motifs monomères répétitifs correspondant à ceux de la matière polymère non élastique,
(ii) les mêmes motifs monomères oxydés et/ou réticulés, et
(iii) une ou plusieurs charges minérales constituées d'éléments métalliques ou semi-métalliques ou des oxydes correspondants,
le procédé consistant à
a) introduire la pièce moulée dans la partie inférieure d'une chambre à vide, et
b) à traiter ladite pièce moulée avec un plasma à faible pression en présence, dans la partie supérieure de ladite chambre à vide, d'une électrode connectée à un générateur d'énergie haute fréquence, tout en maintenant reliée à la terre la partie inférieure de ladite chambre à vide, ladite électrode étant constituée de la charge minérale (iii) sous forme élémentaire ou sous forme oxydée, ce qui permet d'atteindre une concentration atomique de la charge (iii) dans la couche polymère superficielle, mesurée par XPS, qui est comprise entre 1 et 10 %.

2. Procédé conforme à la revendication 1 dans lequel l'électrode est constituée d'un ou de plusieurs membres du groupe formé par l'aluminium, le cuivre, l'indium, l'étain, le silicium et les oxydes correspondants.

3. Procédé conforme à une quelconque des revendications 1 et 2 dans lequel le traitement par plasma est effectué à une pression comprise entre 0,1 et 20 Pascal, le plasma étant de préférence choisi parmi les plasmas à oxygène, air, azote et gaz rares ou des mélanges de ceux-ci.

4. Pièces moulées à base d'une matière polymère non élastomère comportant une couche superficielle de polymère modifié contenant
(i) des motifs monomères répétitifs correspondant à ceux de la matière polymère non élastique,
(ii) tous ou partie des motifs monomères étant oxydés et/ou réticulés, et
(iii) une ou plusieurs charges minérales choisies parmi les métaux ou semi-métaux sous forme élémentaire et/ou oxydée, la ou lesdites charges minérales étant présentes en une concentration atomique, mesurée par XPS, comprise entre 1 et 10%, et ledit polymère modifié se trouvant en interpénétration avec la matière non modifiée du substrat.

5. Pièces conformes à la revendication 4 dans lesquelles l'épaisseur de la couche superficielle de polymère modifié n'excède pas 50 nm et est comprise de préférence entre 0,1 et 15 nm.

6. Pièces conformes à la revendication 5 dans lesquelles l'épaisseur de la couche superficielle de polymère modifié est comprise entre 1 et 10 nm.

7. Pièces conformes à une quelconque des revendications précédentes dans lesquelles le métal ou semi-métal est choisi parmi l'aluminium, le cuivre, l'indium, l'étain, le silicium ou des mélanges de ceux-ci.

8. Pièce conforme à la revendication 7 dans laquelle le métal est l'aluminium.

9. Pièce conforme à une quelconque des revendications 7 et 8 dans laquelle le métal ou semi-métal est présent sous forme d'un oxyde.
